# EUROPÄISCHE PATENTANMELDUNG

(11) **EP 4 517 361 A1**
(43) Veröffentlichungstag der Anmeldung: **05.03.2025**
(21) Anmeldenummer: 23194791.2
(22) Anmeldetag: 01.09.2023
(51) Int. Cl.: G01R 33/58

(54) **INITIALISIERUNG EINES MAGNETRESONANZGERÄTES HINSICHTLICH DER GRADIENTENSPULENEINHEIT**

(71) Anmelder: Siemens Healthineers AG, 91301 Forchheim (DE)
(72) Erfinder: Beck, Thomas, 91077 Dormitz (DE); Fath, Sascha, 91052 Erlangen (DE); Helmecke, Sven, 90427 Nürnberg (DE); Prinz, Carsten, 91083 Baiersdorf (DE); Riegler, Jörg, 90766 Fürth (DE)
(74) Vertreter: Siemens Healthineers Patent Attorneys

(57) **Zusammenfassung**

Die Erfindung betrifft ein Verfahren zu einer Initialisierung eines Magnetresonanzgerätes hinsichtlich einer Gradientenspuleneinheit, welche Gradientenspuleneinheit einen zylindrischen Patientenaufnahmebereich mit einer Zylinderachse entsprechend einer Längsachse des Magnetresonanzgerätes umschließt, gemäß den folgenden Verfahrensschritten:
- Bereitstellung eines Testobjektes aufweisend eine räumliche Ausdehnung entlang zumindest einer ersten Achse und aufweisend eine Achsenasymmetrie bezüglich zumindest zwei zur ersten Achse senkrechten Achsen,
- Positionierung des Testobjektes innerhalb des Patientenaufnahmebereiches mit der ersten Achse parallel zur Längsachse,
- Bereitstellung von Magnetresonanzdaten des Testobjektes positioniert innerhalb des Patientenaufnahmebereiches,
- Bereitstellung von Referenzdaten des Testobjektes,
- Bestimmung Transformationsmatrix durch Vergleich der Magnetresonanzdaten mit den Referenzdaten, welche Transformationsmatrix die Magnetresonanzdaten auf die Referenzdaten abbildet, und eine rigide Abbildung beschreibt,
- Bereitstellung der Transformationsmatrix.

## Beschreibung

Die Erfindung betrifft ein Verfahren und ein Magnetresonanzgerät zu einer Initialisierung eines Magnetresonanzgerätes hinsichtlich der Gradientenspuleneinheit.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse, beispielsweise Anregungspulse, ausgesendet, was dazu führt, dass die Kernspins bestimmter, durch diese Hochfrequenz-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Eine Gradientenspuleneinheit umfasst typischerweise drei Gradientenspulen. Eine Gradientenspule ist typischerweise zur Erzeugung eines Magnetfeldgradienten in eine Raumrichtung ausgelegt. Gradientenspulen werden mit elektrischen Strömen gesteuert, deren Amplituden mehrere 100 A erreichen und die häufigen und raschen Wechseln der Stromrichtung mit Anstiegs- und Abfallraten von mehreren 100 kA/s unterliegen. Hierfür ist eine Gradientenspuleneinheit mit einer Gradientensteuereinheit verbunden. Die Gradientensteuereinheit umfasst hierfür typischerweise drei Spannungsquellen und/oder drei Gradientenverstärkereinheiten, wobei jeweils eine Gradientenspule mit jeweils einer Spannungsquelle und/oder einer Gradientenverstärkereinheit verbunden ist. Hierzu ist die Gradientenspuleneinheit mit der Gradientensteuereinheit durch eine Gradientenanschlusseinheit elektrisch verbunden. Die Gradientensteuereinheit ist typischerweise beabstandet zur Detektoreinheit angeordnet, insbesondere um eine elektromagnetische Wechselwirkung zwischen Detektoreinheit und Gradientensteuereinheit zu minimieren. Das Magnetresonanzgerät ist typischerweise innerhalb eines HF-abgeschirmten Raumes angeordnet, die Gradientensteuereinheit außerhalb des HF-abgeschirmten Raumes. Der Abstand zwischen der Gradientensteuereinheit und der Detektoreinheit beträgt typischerweise mehr als zwei Meter. Die Gradientenanschlusseinheit ist herkömmlich derart ausgestaltet, dass dieser Abstand überwunden wird und die Bewegungsfreiheit um die Detektoreinheit nicht eingeschränkt wird. Hierzu werden von der Gradientenanschlusseinheit umfasste Kabel typischerweise von der Detektoreinheit nach oben, insbesondere in Richtung der Decke des Raumes, oder nach unten, also in Richtung des Bodens des Raumes, geführt. Diese Kabel können gebogen oder gekrümmt und entsprechend fixiert werden. Es ist auch möglich, eine Gradientenanschlusseinheit mit Rotationsplatte und Verbindungselementen, wie in DE 20 2023 101 042 beschrieben, zu verwenden, sodass eine Installation des Magnetresonanzgerätes mit Führung der Kabel in Richtung der Decke des Raumes und eine Führung der Kabel in Richtung des Bodens des Raumes mit gleichen Bauteilen möglich ist, wobei die Gradientenanschlusseinheit dennoch robust ist. Hierbei ist jedoch insbesondere ein korrekter Anschluss der Kabel und deren Polarität, insbesondere deren Anschlussrichtung, essentiell.

Der Erfindung liegt die Aufgabe zugrunde, ein besonders einfaches und genaues Verfahren zu einer Initialisierung eines Magnetresonanzgerätes umfassend eine Gradientenspuleneinheit und eine Steuereinheit hinsichtlich der Gradientenspuleneinheit, insbesondere hinsichtlich einer Polarität der Gradientenspuleneinheit, anzugeben. Die Aufgabe wird durch die Merkmale der unabhängigen Ansprüche gelöst. Vorteilhafte Ausgestaltungen sind in den Unteransprüchen beschrieben.

Das erfindungsgemäße Verfahren zu einer Initialisierung eines Magnetresonanzgerätes umfassend eine Gradientenspuleneinheit und eine Steuerungseinheit sieht vor, dass die Gradientenspuleneinheit einen zylindrischen Patientenaufnahmebereich mit einer Zylinderachse entsprechend einer Längsachse des Magnetresonanzgerätes umschließt und die Initialisierung hinsichtlich der Gradientenspuleneinheit, insbesondere hinsichtlich der Polarität, der Gradientenspuleneinheit erfolgt. Das erfindungsgemäße Verfahren sieht die folgenden Verfahrensschritte vor:
- Bereitstellung eines Testobjektes aufweisend eine räumliche Ausdehnung entlang zumindest einer ersten Achse und aufweisend eine Achsenasymmetrie bezüglich zumindest zwei zur ersten Achse senkrechten Achsen,
- Positionierung des Testobjektes innerhalb des Patientenaufnahmebereiches mit der ersten Achse parallel zur Längsachse,
- Bereitstellung von Magnetresonanzdaten des Testobjektes positioniert innerhalb des Patientenaufnahmebereiches,
- Bereitstellung von Referenzdaten des Testobjektes,
- Bestimmung Transformationsmatrix durch Vergleich der Magnetresonanzdaten mit den Referenzdaten, welche Transformationsmatrix die Magnetresonanzdaten auf die Referenzdaten abbildet, und eine rigide Abbildung beschreibt,
- Bereitstellung der Transformationsmatrix in der Steuerungseinheit.

Die Gradientenspuleneinheit ist typischerweise hohlzylindrisch ausgebildet. Die Gradientenspuleneinheit umschließt typischerweise einen zylindrischen Patientenaufnahmebereich und/oder ist konzentrisch zu diesem angeordnet. Die Zylinderachse des Patientenaufnahmebereichs entspricht typischerweise der Zylinderachse der Gradientenspuleneinheit. Die Längsachse des Magnetresonanzgerätes entspricht typischerweise der Zylinderachse der Gradientenspuleneinheit und/oder ist horizontal angeordnet.

Das erfindungsgemäße Verfahren wird typischerweise im Rahmen der Inbetriebnahme des Magnetresonanzgerätes ausgeführt, typischerweise einmalig. Eine Initialisierung des Magnetresonanzgerätes umfasst typischerweise eine Justierung und/oder Kalibrierung, insbesondere bei Installation, insbesondere bei Erstinstallation, des Magnetresonanzgerätes. Die Initialisierung kann eine Vermessung des Hauptmagnetfeldes und/oder der Gradientenspuleneinheit und/oder eines Magnetfeldgradienten und/oder einer Hochfrequenzantenneneinheit und/oder eines Hochfrequenzfeldes umfassen. Die Initialisierung kann Maßnahmen zur Homogenisierung von Magnetfeldern umfassen. Die Initialisierung kann im Rahmen der Installation des Magnetresonanzgerätes und/oder im Rahmen einer Patientenuntersuchung, insbesondere vor Beginn einer Untersuchung eines Untersuchungsobjektes, durchgeführt werden.

Die Gradientenspuleneinheit umfasst typischerweise eine Gradientenanschlusseinheit, welche Kabel umfasst. Die Gradientenanschlusseinheit verbindet typischerweise die Gradientenspuleneinheit mit der Steuerungseinheit und/oder der Gradientensteuereinheit. Die Gradientenspuleneinheit umfasst hierfür typischerweise mehrere Anschlüsse, wobei eine Verbindung zwischen jeweils einem Kabel mit jeweils einem der mehreren Anschlüsse vorgesehen ist. Grundsätzlich ist typischerweise jedes der Kabel mit jedem der Anschlüsse verbindbar. Die Führung und/oder die Richtung des Anschlusses der Kabel und/oder die Wahl des korrekten Anschlusses für jedes der Kabel ist essentiell, da dies insbesondere die Richtung und/oder die Polarität der Ortskodierung mittels der Gradientenspuleneinheit bestimmt. Die Initialisierung des Magnetresonanzgerätes hinsichtlich der Gradientenspuleneinheit, insbesondere hinsichtlich deren Polarität, umfasst typischerweise eine Überprüfung der Gradientenanschlusseinheit, insbesondere der Richtigkeit der Verbindungen zwischen der Gradientenspuleneinheit und der Steuerungseinheit und/oder der Gradientensteuereinheit. Insbesondere die Anschlussrichtung der Gradientenanschlusseinheit kann als Polarität der Gradientenspuleneinheit bezeichnet werden.

Das Testobjekt ist typischerweise ein physisches Objekt, welches im Betrieb des Magnetresonanzgerätes Magnetresonanz-Signale aussendet. Das Testobjekt kann eine äußere Form und/oder eine innenliegende Struktur aufweisen, welche asymmetrisch hinsichtlich zumindest zwei Achsen ist, welche zwei Achsen zu einer ersten Achse senkrecht sind. Das Testobjekt ist vorzugsweise derart ausgestaltet, dass es mit erster Achse in horizontaler Richtung stabil auf einer ebenen horizontalen Fläche positionierbar ist. Das Testobjekt wird im Rahmen des erfindungsgemäßen Verfahrens parallel zur Längsachse, insbesondere parallel zur Zylinderachse des Patientenaufnahmebereiches angeordnet, vorzugsweise auf einer Patientenlagerungsvorrichtung. Das Testobjekt wird vorzugsweise zumindest teilweise in einem Isozentrum des Magnetresonanzgerätes angeordnet.

Die Magnetresonanzdaten des Testobjektes umfassen vorzugsweise Magnetresonanz-Signale, welche das Testobjekt im Betrieb des Magnetresonanzgerätes aussendet. Die Referenzdaten des Testobjektes umfassen typischerweise Informationen des Testobjektes, insbesondere hinsichtlich Geometrie, Form, Struktur und/oder Position. Die Transformationsmatrix kann eine mathematische Funktion und/oder eine Abbildung umfassen. Eine rigide Abbildung kann insbesondere homomorph und/oder unelastisch sein. Die Bereitstellung der Transformationsmatrix in der Steuerungseinheit kann ein Speichern der Transformationsmatrix umfassen. Die Bestimmung der Transformationsmatrix kann unter Verwendung automatisierter Bildverarbeitung und/oder maschineller Lernverfahren und/oder künstlicher Intelligenz erfolgen. Die Transformationsmatrix wird vorzugsweise im Rahmen aller folgenden Messungen durch die Steuerungseinheit, insbesondere die Gradientensteuereinheit verwendet. Insbesondere können bei einer MR-Bildgebung eines Untersuchungsobjektes im Rahmen der Kalibrierung des Magnetresonanzgerätes hinsichtlich des Untersuchungsobjektes die Transformationsmatrix bereits bei der Ansteuerung des Magnetresonanzgerätes berücksichtigt werden, insbesondere auch bei der MR-Bildgebung des Untersuchungsobjektes an sich.

Eine derart bestimmte Transformationsmatrix kann auch von einem Benutzer, insbesondere einem Servicetechniker, überprüft werden. Beispielsweise kann durch Anwendung der Transformationsmatrix auf die Magnetresonanzdaten des Testobjektes und einen Vergleich deren mit den Referenzdaten die Transformationsmatrix visuell überprüft werden. Es ist auch denkbar, dass ein Benutzer, insbesondere ein Servicetechniker, diese Transformationsmatrix manuell korrigiert und/oder anpasst und/oder bestimmt.

Das erfindungsgemäße Verfahren ermöglicht demnach eine besonders einfache und genaue Kalibrierung und Initialisierung des Magnetresonanzgerätes. Insbesondere bei Magnetresonanzgeräten, bei welchen eine Führung der Kabel in Richtung der Decke des Raumes und eine Führung der Kabel in Richtung des Bodens des Raumes mit gleichen Bauteilen möglich ist, kann ein korrekter Anschluss der Kabel und damit Funktionsweise der Gradientenspuleneinheit sichergestellt werden.

Eine Ausführungsform des Verfahrens sieht vor, dass die Bereitstellung von Magnetresonanzdaten des Testobjektes eine Akquisition der Magnetresonanzdaten, insbesondere eine Aufnahme der Magnetresonanzdaten, des Testobjektes mittels des Magnetresonanzgerätes umfasst. Die Akquisition der Magnetresonanzdaten des Testobjektes erfolgt vorzugsweise während das Testobjekt im Patientenaufnahmebereich mit der ersten Achse parallel zur Längsachse, insbesondere im Isozentrum des Magnetresonanzgerätes positioniert ist. Dies ermöglicht eine besonders genaue Kalibrierung des Magnetresonanzgerätes.

Eine Ausführungsform des Verfahrens sieht vor, dass die Bestimmung der Transformationsmatrix iterativ erfolgt und die folgenden Verfahrensschritte umfasst:
a) Erzeugung von iterierten Magnetresonanzdaten durch Anwendung der Transformationsmatrix auf die Magnetresonanzdaten
b) Bestimmung einer weiteren Transformationsmatrix durch Vergleich der iterierten Magnetresonanzdaten mit den Referenzdaten
c) Aktualisierung der Transformationsmatrix unter Berücksichtigung der weitere Transformationsmatrix
d) Bereitstellung der aktualisierten Transformationsmatrix als Transformationsmatrix.

Im Rahmen der erfindungsgemäßen Bereitstellung der Transformationsmatrix kann gemäß dieser Ausführungsform die aktualisierte Transformationsmatrix bereitgestellt werden. Diese Ausführungsform ermöglicht eine besonders präzise Bestimmung der Transformationsmatrix.

Eine Ausführungsform des Verfahrens sieht vor, dass die Verfahrensschritte a), b), c) und d) wiederholt ausgeführt werden. Diese Ausführungsform ermöglicht die Extraktion einer optimalen Transformationsmatrix.

Eine Ausführungsform des Verfahrens umfasst zusätzlich eine weitere Akquisition von weiteren Magnetresonanzdaten des Testobjektes unter Berücksichtigung der Transformationsmatrix, wobei in Verfahrensschritt a) die Erzeugung von iterierten Magnetresonanzdaten durch Anwendung der Transformationsmatrix auf die weiteren Magnetresonanzdaten erfolgt. Im Rahmen der weiteren Akquisition werden Magnetresonanz-Signale aufgenommen. Im Rahmen der Verarbeitung, insbesondere der Rekonstruktion der Magnetresonanz-Signale zu Bilddaten und/oder der Bildverarbeitung derart gewonnener Bilddaten, wird typischerweise ein Algorithmus verwendet, welcher die Transformationsmatrix berücksichtigt. Die weiteren Magnetresonanzdaten unterliegen demnach der Korrektur durch die Transformationsmatrix und/oder wurden mittels dieser moduliert. Ein Vergleich der weiteren Magnetresonanzdaten mit den Referenzdaten weist typischerweise geringere Unterschiede auf als der Vergleich der Magnetresonanzdaten mit den Referenzdaten. Diese Ausführungsform ermöglicht eine besonders gute Überprüfung, insbesondere auch visuelle Überprüfung durch einen Servicetechniker oder Benutzer, und Optimierung der Transformationsmatrix für eine besonders präzise Korrektur.

Eine Ausführungsform des Verfahrens umfasst zusätzlich eine Bereitstellung von definierten Operatoren umfassend eine Spiegelung und/oder eine Rotation, wobei die Bestimmung der Transformationsmatrix eine Selektion zumindest eines Operators der definierten Operatoren umfasst. Die definierten Operatoren sind typischerweise mathematische Operatoren beschreibend eine geometrische Abbildung. Insbesondere eine Spiegelung und/oder eine Rotation beschreiben mögliche Varianten des Einbaus und der Gradientenspuleneinheit, wie beispielsweise eine Drehung um die Zylinderachse, und Varianten der Gradientenanschlusseinheit, wie beispielsweise vertauschte Kabel, sodass ein derartiger Operator die Abbildung zwischen Magnetresonanzdaten und Referenzdaten beschreiben kann. Die Transformationsmatrix kann weitere Abbildungsvorschriften umfassen. Diese Ausführungsform ermöglicht eine besonders einfache und effiziente Initialisierung des Magnetresonanzgerätes.

Eine Ausführungsform des Verfahrens sieht vor, dass die Bestimmung der Transformationsmatrix auf die Selektion zumindest eines Operators der definierten Operatoren beschränkt ist. Diese Operatoren ermöglichen eine Korrektur der stärksten Einflüsse verschiedener Varianten des Einbaus der Gradientenspuleneinheit auf Bilddaten, insbesondere vertauschte Kabel und/oder eine geringfügige Drehung der Gradientenspuleneinheit um die Zylinderachse. Diese Ausführungsform ermöglicht eine besonders einfache und effiziente Initialisierung des Magnetresonanzgerätes.

Eine Ausführungsform des Verfahrens sieht vor, dass die Transformationsmatrix eine homomorphe Abbildung beschreibt.

Eine Ausführungsform des Verfahrens sieht vor, dass die Transformationsmatrix eine Spiegelung und/oder eine Rotation beschreibt. Vertauschte Kabel können die Polarität der Magnetfeldgradienten einer Gradientenspuleneinheit ändern, was zu gespiegelten Magnetresonanzdaten des Testobjektes führt. Dies kann mittels Spiegelung korrigiert werden. Eine um die Zylinderachse gedreht eingebaute Gradientenspuleneinheit bewirkt eine Rotation der Magnetresonanzdaten des Testobjektes im Vergleich zu den Referenzdaten, was mittels Rotation korrigiert werden kann. Diese Ausführungsform ermöglicht eine besonders einfache und effiziente Initialisierung des Magnetresonanzgerätes.

Eine Ausführungsform des Verfahrens sieht vor, dass die Transformationsmatrix frei von einer Translation und/oder einer Streckung ist. Ein Abbildungsfehler, insbesondere eine Abweichung zwischen Magnetresonanzdaten des Testobjektes und den Referenzdaten, aufgrund von Toleranzen beim Einbau einer Gradientenspuleneinheit in das Magnetresonanzgerät, ist typischerweise frei von einer Translation und/oder einer Streckung. Folglich kann eine derartige Transformationsmatrix einfach die Abbildung der Referenzdaten auf die Magnetresonanzdaten des Testobjektes beschreiben.

Eine Ausführungsform des Verfahrens sieht vor, dass die Referenzdaten ein Bild und/oder Magnetresonanzdaten und/oder Landmarken eines Referenz-Testobjektes aufgenommen mit einem Referenz-Magnetresonanzgerät, umfassend eine Gradientenspuleneinheit mit korrekter Polarität, umfassen. Die Referenzdaten können demnach Bilddaten und/oder Rohdaten umfassen. Sind die Magnetresonanzdaten des Testobjektes als Bilddaten ausgebildet, so umfassen die Referenzdaten vorzugsweise Bilddaten. Sind die Magnetresonanzdaten des Testobjektes als Rohdaten ausgebildet, so umfassen die Referenzdaten vorzugsweise Rohdaten. Insbesondere bei Ausbildung der Referenzdaten als Bilddaten können die Referenzdaten auch Landmarken umfassen. Das Referenz-Testobjekt kann dem Testobjekt entsprechen und/oder analog zum Testobjekt ausgebildet sein. Der Vergleich der Magnetresonanzdaten mit den Referenzdaten kann einen Vergleich von Landmarken des Testobjektes mit Landmarken des Referenz-Testobjektes umfassen. Das Referenz-Magnetresonanzgerät weist typischerweise eine korrekte Initialisierung auf und/oder stellt Objekte, insbesondere das Referenz-Testobjekt, möglichst realitätstreu dar. Die Transformationsmatrix kann gemäß dieser Ausführungsform besonders präzise bestimmt werden, da insbesondere der Vergleich auf real aufgenommenen Referenzdaten basiert.

Eine Ausführungsform des Verfahrens sieht vor, dass die erste Achse entlang der Längsachse ausgerichtet ist. Eine derartige Positionierung stellt sicher, dass das Testobjekt im Isozentrum des Magnetresonanzgerätes im Rahmen der Initialisierung des Magnetresonanzgerätes positioniert ist. In diesem Bereich des Patientenaufnahmebereiches ist eine korrekte Funktionsweise der Gradientenspuleneinheit besonders wichtig.

Eine Ausführungsform des Verfahrens sieht vor, dass die Magnetresonanzdaten des Testobjektes Bilddaten oder Rohdaten umfassen. Die Referenzdaten des Testobjektes können Bilddaten oder Rohdaten umfassen. Rohdaten werden typischerweise mittels eines Algorithmus zu Bilddaten rekonstruiert. Rohdaten umfassen typischerweise Magnetresonanz-Signale im Rohdatenraum, insbesondere im k-Raum. Die Transformationsmatrix kann eine Abbildung im Rohdatenraum oder im Bildraum beschreiben. Umfassen die Magnetresonanzdaten des Testobjektes Bilddaten und/oder die Referenzdaten Bilddaten, so kann die Transformationsmatrix anhand der Magnetresonanzdaten des Testobjektes visuell durch einen Benutzer überprüft werden. Rohdaten können Merkmale umfassen, welche eine robustere oder präzisere Bestimmung der Transformationsmatrix ermöglichen können.

Eine Ausführungsform des Verfahrens sieht vor, dass die Bereitstellung der Transformationsmatrix in der Steuerungseinheit eine Verwendung der Transformationsmatrix im Rahmen einer folgenden Magnetresonanzmessung eines Untersuchungsobjektes umfasst. Eine Magnetresonanzmessung umfasst eine Aufnahme von Bilddaten eines Untersuchungsobjektes. Diese Ausführungsform stellt eine Verwendung der Transformationsmatrix und damit eine korrekte Funktionsweise der Gradientenspuleneinheit sicher.

Des Weiteren geht die Erfindung aus von einem Magnetresonanzgerät mit einer Detektoreinheit mit einem Hauptmagneten, einer Hochfrequenzantenneneinheit, und einer Gradientenspuleneinheit, welche Gradientenspuleneinheit einen zylindrischen Patientenaufnahmebereich mit einer Zylinderachse entsprechend einer Längsachse des Magnetresonanzgerätes umschließt. Das Magnetresonanzgerät umfasst zudem ein Testobjekt und eine Steuerungseinheit mit einer Initialisierungseinheit. Die Initialisierungseinheit ist dazu ausgebildet, ein erfindungsgemäßes Verfahren zu einer Initialisierung des Magnetresonanzgerätes hinsichtlich der Gradientenspuleneinheit auszuführen.

Dafür weist die Initialisierungseinheit typischerweise einen Eingang, eine Prozessoreinheit und einen Ausgang auf. Über den Eingang können der Initialisierungseinheit Magnetresonanzdaten des Testobjektes und/oder Referenzdaten und/oder definierte Operatoren bereitgestellt werden. Weitere, im Verfahren benötigte Funktionen, Algorithmen oder Parameter können der Initialisierungseinheit über den Eingang bereitgestellt werden. Die Transformationsmatrix und/oder weitere Ergebnisse einer Ausführungsform des erfindungsgemäßen Verfahrens können über den Ausgang bereitgestellt werden. Die Initialisierungseinheit kann in das Magnetresonanzgerät integriert sein. Die Initialisierungseinheit kann auch separat von dem Magnetresonanzgerät installiert sein. Die Initialisierungseinheit kann mit dem Magnetresonanzgerät verbunden sein.

Ausführungsformen des erfindungsgemäßen Magnetresonanzgerätes sind analog zu den Ausführungsformen des erfindungsgemäßen Verfahrens ausgebildet. Das Magnetresonanzgerät kann weitere Steuerungskomponenten aufweisen, welche zum Ausführen eines erfindungsgemäßen Verfahrens nötig und/oder vorteilhaft sind. Auch kann das Magnetresonanzgerät dazu ausgebildet sein, Steuerungssignale zu senden und/oder Steuerungssignale zu empfangen und/oder zu verarbeiten, um ein erfindungsgemäßes Verfahren auszuführen. Vorzugsweise ist die Initialisierungseinheit Teil der Steuerungseinheit des erfindungsgemäßen Magnetresonanzgeräts. Auf einer Speichereinheit der Initialisierungseinheit können Computerprogramme und weitere Software gespeichert sein, mittels derer die Prozessoreinheit der Initialisierungseinheit einen Verfahrensablauf eines erfindungsgemäßen Verfahrens automatisch steuert und/oder ausführt.

Die Vorteile des erfindungsgemäßen Magnetresonanzgeräts entsprechen im Wesentlichen den Vorteilen des erfindungsgemäßen Verfahrens zu einer Initialisierung des Magnetresonanzgerätes hinsichtlich der Gradientenspuleneinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.
Es zeigen:
- Fig. 1: ein erfindungsgemäßes Magnetresonanzgerät in einer schematischen Darstellung,
- Fig. 2: eine Ausführungsform eines Testobjektes in einer Ansicht senkrecht zur ersten Achse in einer schematischen Darstellung,
- Fig. 3: ein Ablaufdiagramm einer ersten Ausführungsform eines erfindungsgemäßen Verfahrens, und
- Fig. 4: ein Ablaufdiagramm einer zweiten Ausführungsform eines erfindungsgemäßen Verfahrens.

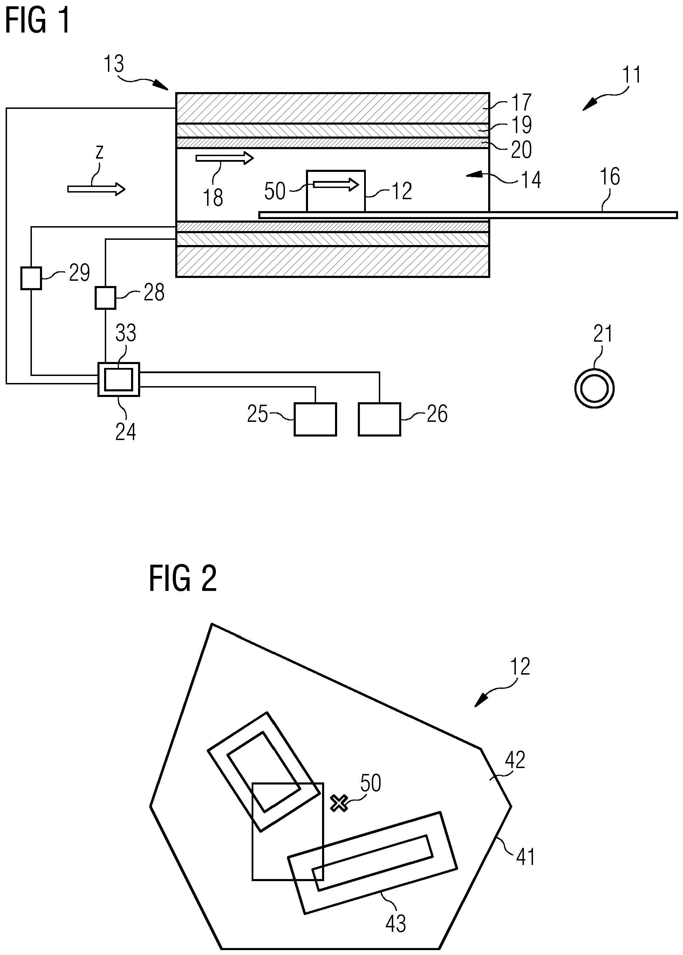

Figur 1 zeigt ein Magnetresonanzgerät 11 zur Ausführung eines erfindungsgemäßen Verfahrens in einer schematischen Darstellung. Das Magnetresonanzgerät 11 umfasst eine Detektoreinheit 13 mit einem Hauptmagneten 17 zu einem Erzeugen eines starken und insbesondere konstanten Hauptmagnetfelds 18, insbesondere parallel zur Zylinderachse z des Patientenaufnahmebereiches 14. Zudem weist das Magnetresonanzgerät 11 einen zylinderförmigen Patientenaufnahmebereich 14 zu einer Aufnahme eines nicht näher dargestellten Patienten auf, wobei der Patientenaufnahmebereich 14 in einer Umfangsrichtung von der Detektoreinheit 13 zylinderförmig umschlossen ist. Die Zylinderachse z des Patientenaufnahmebereiches 14 entspricht der Längsachse des Magnetresonanzgerätes 11. Der Patient kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist. Das erfindungsgemäße Magnetresonanzgerät 11 umfasst ein Testobjekt 12, das anstelle des Patienten auf der Patientenlagerungsvorrichtung 16 positionierbar ist und von welchem mittels der Detektoreinheit 13 Magnetresonanzdaten aufgenommen werden können. Die erste Achse 50 des Testobjektes 12 ist dabei parallel, insbesondere entlang zur Längsachse z ausgerichtet.

Die Detektoreinheit 13 weist weiterhin eine Gradientenspuleneinheit 19 auf, die für eine Ortskodierung während einer Bildgebung verwendet werden. Die Gradientenspuleneinheit 19 wird mittels einer Gradientensteuereinheit 28 angesteuert. Des Weiteren weist die Detektoreinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Die Steuerungseinheit 24 umfasst weiterhin eine Initialisierungseinheit 33. Die Initialisierungseinheit 33 ist zudem zu einer Ausführung eines Verfahrens zu einer Initialisierung eines Magnetresonanzgerätes hinsichtlich der Gradientenspuleneinheit ausgelegt. Hierzu weist die Initialisierungseinheit 33 Computerprogramme und/oder Software auf, die direkt in einem nicht näher dargestellten Speichereinheit der Initialisierungseinheit 33 ladbar sind, mit Programmmitteln, um ein Verfahren zu einer Initialisierung eines Magnetresonanzgerätes hinsichtlich der Gradientenspuleneinheit auszuführen, wenn die Computerprogramme und/oder Software in der Initialisierungseinheit 33 ausgeführt werden. Die Initialisierungseinheit 33 weist hierzu einen nicht näher dargestellten Prozessor auf, der zu einer Ausführung der Computerprogramme und/oder Software ausgelegt ist. Alternativ hierzu können die Computerprogramme und/oder Software auch auf einem getrennt von der Steuerungseinheit 24 und/oder Initialisierungseinheit 33 ausgebildeten elektronisch lesbaren Datenträger 21 gespeichert sein, wobei ein Datenzugriff von der Initialisierungseinheit 33 auf den elektronisch lesbaren Datenträger 21 über ein Datennetz erfolgen kann.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird. Das Magnetresonanzgerät 11 ist somit zusammen mit der Initialisierungseinheit 33 zur Ausführung eines erfindungsgemäßen Verfahrens ausgelegt.

Ein Verfahren zu einer Initialisierung eines Magnetresonanzgerätes hinsichtlich der Gradientenspuleneinheit kann auch in Form eines Computerprogrammprodukts vorliegen, das das Verfahren auf die Initialisierungseinheit 33 implementiert, wenn es auf der Initialisierungseinheit 33 ausgeführt wird. Ebenso kann ein elektronisch lesbarer Datenträger 21 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 21 in einer Initialisierungseinheit 33 eines Magnetresonanzgeräts 11 das beschriebene Verfahren durchführen.

Figur 2 zeigt eine Ausführungsform eines Testobjektes 12 in einer Ansicht, insbesondere einen Querschnitt senkrecht zur ersten Achse, in einer schematischen Darstellung. Das Testobjekt 12 weist eine räumliche Ausdehnung entlang der ersten Achse 50 und eine Achsenasymmetrie bezüglich zumindest zwei zur ersten Achse 50 senkrechten Achsen auf. Hierfür kann das Testobjekt 12 einen Behälter 41 umfassen, welcher beispielsweise mit einem Liquid 42 befüllt ist. Innerhalb des Behälters 41 können zusätzlich Strukturen 43, typischerweise umfassen Plastik, angeordnet sein. Die Achsenasymmetrie bezüglich zumindest zwei zur ersten Achse 50 senkrechten Achsen kann dabei durch die Form des Behälters 41 und/oder die Form der Strukturen 43 erzielt werden. Das Liquid 42 strahlt typischerweise Magnetresonanz-Signale ab. Die Magnetresonanzdaten des Testobjektes können demnach Signal an Positionen des Liquids 42 umfassen, wobei Strukturen 43 dunkel erscheinen können.

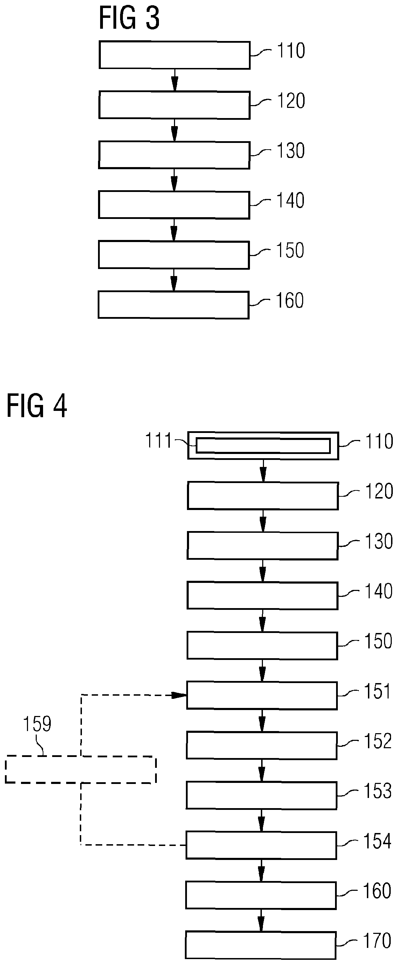

Figur 3 zeigt ein Ablaufdiagramm einer ersten Ausführungsform eines erfindungsgemäßen Verfahrens zu einer Initialisierung eines Magnetresonanzgerätes umfassend eine Gradientenspuleneinheit hinsichtlich der Gradientenspuleneinheit.

Diese Ausführungsform des Verfahrens umfasst mit Verfahrensschritt 110 die Bereitstellung eines Testobjektes 12 aufweisend eine räumliche Ausdehnung entlang zumindest einer ersten Achse 50 und aufweisend eine Achsenasymmetrie bezüglich zumindest zwei zur ersten Achse 50 senkrechten Achsen. Der folgenden Verfahrensschritt 120 umfasst die Positionierung des Testobjektes 12 innerhalb des Patientenaufnahmebereiches 14 mit der ersten Achse 50 parallel zur Längsachse z. Der folgenden Verfahrensschritt 130 sieht eine Bereitstellung von Magnetresonanzdaten des Testobjektes 12 positioniert innerhalb des Patientenaufnahmebereiches 14 vor. In Verfahrensschritt 140 erfolgt die Bereitstellung von Referenzdaten. Bei der Bestimmung Transformationsmatrix erfolgt mit Verfahrensschritt 150 ein Vergleich der Magnetresonanzdaten mit den Referenzdaten, welche Transformationsmatrix die Magnetresonanzdaten auf die Referenzdaten abbildet, und eine rigide Abbildung beschreibt. In Verfahrensschritt 160erfolgt die Bereitstellung der Transformationsmatrix in der Steuerungseinheit 24.

Figur 4 zeigt ein Ablaufdiagramm einer zweiten Ausführungsform eines erfindungsgemäßen Verfahrens zu einer Initialisierung eines Magnetresonanzgerätes umfassend eine Gradientenspuleneinheit hinsichtlich der Gradientenspuleneinheit. Die zweite Ausführungsform unterscheidet sich von der ersten Ausführungsform insbesondere darin, dass die Bestimmung der Transformationsmatrix iterativ erfolgt. Hierzu sieht Verfahrensschritt 151 eine Erzeugung von iterierten Magnetresonanzdaten durch Anwendung der Transformationsmatrix auf die Magnetresonanzdaten vor. Im folgenden Verfahrensschritt 152 erfolgt die Bestimmung einer weiteren Transformationsmatrix durch Vergleich der iterierten Magnetresonanzdaten mit den Referenzdaten. Verfahrensschritt 153 sieht eine Aktualisierung der Transformationsmatrix unter Berücksichtigung der weitere Transformationsmatrix vor. Verfahrensschritt 154 umfasst die Bereitstellung der aktualisierten Transformationsmatrix als Transformationsmatrix. Hierbei können die Verfahrensschritte 151, 152, 153, 154 wiederholt ausgeführt werden. Zudem kann das Verfahren mit Verfahrensschritt 159 eine weitere Akquisition von weiteren Magnetresonanzdaten des Testobjektes 12 unter Berücksichtigung der Transformationsmatrix umfassen, wobei in Verfahrensschritt 151 die Erzeugung von iterierten Magnetresonanzdaten durch Anwendung der Transformationsmatrix auf die weiteren Magnetresonanzdaten erfolgt.

Zusätzlich kann die Bereitstellung von Magnetresonanzdaten des Testobjektes gemäß Verfahrensschritt 110 mit Verfahrensschritt 111 eine Akquisition der Magnetresonanzdaten des Testobjektes 12 mittels des Magnetresonanzgerätes umfassen. Zudem kann die in der Steuerungseinheit gemäß Verfahrensschritt 160 bereitgestellte Transformationsmatrix im Rahmen einer Magnetresonanzmessung eines Untersuchungsobjektes in einem Verfahrensschritt 170 verwendet werden. Insbesondere die Verfahrensschritte 111 und 170 können unabhängig voneinander und unabhängig von den Verfahrensschritten 151, 152, 153, 154, 159 ausgeführt werden.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Unabhängig vom grammatikalischen Geschlecht eines bestimmten Begriffes sind Personen mit männlicher, weiblicher oder anderer Geschlechteridentität mit umfasst.

## Patentansprüche

1. Verfahren zu einer Initialisierung eines Magnetresonanzgerätes umfassend eine Gradientenspuleneinheit und eine Steuerungseinheit hinsichtlich der Gradientenspuleneinheit, welche Gradientenspuleneinheit einen zylindrischen Patientenaufnahmebereich mit einer Zylinderachse entsprechend einer Längsachse des Magnetresonanzgerätes umschließt, gemäß den folgenden Verfahrensschritten:
- Bereitstellung eines Testobjektes aufweisend eine räumliche Ausdehnung entlang zumindest einer ersten Achse und aufweisend eine Achsenasymmetrie bezüglich zumindest zwei zur ersten Achse senkrechten Achsen,
- Positionierung des Testobjektes innerhalb des Patientenaufnahmebereiches mit der ersten Achse parallel zur Längsachse,
- Bereitstellung von Magnetresonanzdaten des Testobjektes positioniert innerhalb des Patientenaufnahmebereiches,
- Bereitstellung von Referenzdaten des Testobjektes,
- Bestimmung Transformationsmatrix durch Vergleich der Magnetresonanzdaten mit den Referenzdaten, welche Transformationsmatrix die Magnetresonanzdaten auf die Referenzdaten abbildet, und eine rigide Abbildung beschreibt,
- Bereitstellung der Transformationsmatrix in der Steuerungseinheit.

2. Verfahren nach Anspruch 1, wobei die Bereitstellung von Magnetresonanzdaten des Testobjektes eine Akquisition der Magnetresonanzdaten des Testobjektes mittels des Magnetresonanzgerätes umfasst.

3. Verfahren nach einem der vorangehenden Ansprüche, wobei die Bestimmung der Transformationsmatrix iterativ erfolgt und die folgenden Verfahrensschritte umfasst:
e) Erzeugung von iterierten Magnetresonanzdaten durch Anwendung der Transformationsmatrix auf die Magnetresonanzdaten
f) Bestimmung einer weiteren Transformationsmatrix durch Vergleich der iterierten Magnetresonanzdaten mit den Referenzdaten
g) Aktualisierung der Transformationsmatrix unter Berücksichtigung der weitere Transformationsmatrix
h) Bereitstellung der aktualisierten Transformationsmatrix als Transformationsmatrix.

4. Verfahren nach Anspruch 3, wobei die Verfahrensschritte a), b), c) und d) wiederholt ausgeführt werden.

5. Verfahren nach einem der Ansprüche 3 bis 4, zusätzlich umfassend eine weitere Akquisition von weiteren Magnetresonanzdaten des Testobjektes unter Berücksichtigung der Transformationsmatrix, wobei in Verfahrensschritt a) die Erzeugung von iterierten Magnetresonanzdaten durch Anwendung der Transformationsmatrix auf die weiteren Magnetresonanzdaten erfolgt.

6. Verfahren nach einem der vorangehenden Ansprüche, zusätzlich umfassend eine Bereitstellung von definierten Operatoren umfassend eine Spiegelung und/oder eine Rotation, wobei die Bestimmung der Transformationsmatrix eine Selektion zumindest eines Operators der definierten Operatoren umfasst.

7. Verfahren nach Anspruch 6, wobei die Bestimmung der Transformationsmatrix auf die Selektion zumindest eines Operators der definierten Operatoren beschränkt ist.

8. Verfahren nach einem der vorangehenden Ansprüche, wobei die Transformationsmatrix eine homomorphe Abbildung beschreibt.

9. Verfahren nach einem der vorangehenden Ansprüche, wobei die Transformationsmatrix eine Spiegelung und/oder eine Rotation beschreibt.

10. Verfahren nach einem der vorangehenden Ansprüche, wobei die Transformationsmatrix frei von einer Translation und/oder einer Streckung ist.

11. Verfahren nach einem der vorangehenden Ansprüche, wobei die Referenzdaten ein Bild und/oder Magnetresonanzdaten und/oder Landmarken eines Referenz-Testobjektes aufgenommen mit einem Referenz-Magnetresonanzgerät, umfassend eine Gradientenspuleneinheit mit korrekter Polarität, umfassen.

12. Verfahren nach einem der vorangehenden Ansprüche, wobei die erste Achse entlang der Längsachse ausgerichtet ist.

13. Verfahren nach einem der vorangehenden Ansprüche, wobei die Magnetresonanzdaten des Testobjektes Bilddaten oder Rohdaten umfassen.

14. Verfahren nach einem der vorangehenden Ansprüche, wobei die Bereitstellung der Transformationsmatrix in der Steuerungseinheit eine Verwendung der Transformationsmatrix im Rahmen einer folgenden Magnetresonanzmessung eines Untersuchungsobjektes umfasst.

15. Magnetresonanzgerät umfassend eine Detektoreinheit mit einem Hauptmagneten, einer Hochfrequenzantenneneinheit, und einer Gradientenspuleneinheit, welche Gradientenspuleneinheit einen zylindrischen Patientenaufnahmebereich mit einer Zylinderachse entsprechend einer Längsachse des Magnetresonanzgerätes umschließt, und umfassend ein Testobjekt und eine Steuerungseinheit mit einer Initialisierungseinheit, ausgebildet zur Ausführung eines Verfahrens zu einer Initialisierung des Magnetresonanzgerätes nach einem der vorangehenden Ansprüche.
